# EUROPEAN PATENT APPLICATION

(11) **EP 4 657 507 A1**
(43) Date of publication of application: **03.12.2025**
(21) Application number: 24178494.1
(22) Date of filing: 28.05.2024
(51) Int. Cl.: H01L 21/56, H01L 23/31, H01L 23/495, H01L 23/00

(54) **A METHOD OF MANUFACTURING A SINGULATED SEMICONDUCTOR PRODUCT AS WELL AS A SINGULATED SEMICONDUCTOR PRODUCT OBTAINED BY THIS METHOD**

(71) Applicant: Nexperia B.V., 6534 AB Nijmegen (NL)
(72) Inventor: YANDOC, Ricardo, Manchester, SK7 5BJ (GB); MILO, Dolores, Manchester (GB); BROWN, Adam, Manchester, SK7 5BJ (GB)
(74) Representative: Pjanovic, Ilija

(57) **Abstract**

According to a first example of the disclosure, a method for manufacturing a singulated semiconductor product from a package is proposed. The method comprises the steps of a) providing the bottom frame with the clip matrix with at least one semiconductor component and placing them in a mould cavity, b) closing the mould, c) moving a number of retractable pins through openings in the mould, so that tips of the pins come into contact with the tie bars or the clip tie-bars of the clip matrix at predetermined locations, d) performing moulding operation using the encapsulating material, e) retracting said retractable pins away from the package, f) opening the mould, g) removing the package from the mould, and h) singulating the package into at least one separate product by sawing along predetermined lines and trimming the microleads. With the above steps at least one encapsulated and singulated semiconductor product is formed, that has notches formed on the sides thereof, that expose either tie bars or clip tie-bars.

## Description

### TECHNICAL FIELD

The present disclosure relates to methods of producing encapsulated packages, that are later singulated into separate products containing electronic semiconductor components.

### BACKGROUND OF THE DISCLOSURE

In the prior art, there are known many different clip bonded packages that contain electronic semiconductor components, and depending on their structure - special methods of production have been developed, in order to ensure precision, quality and to keep manufacturing costs relatively acceptable.

In known methods of producing semiconductor devices - parts that will constitute a final product, i.e. metal frames and semiconductor components, are placed in a mould for encapsulation with resin or similarly suitable material. However, when producing large amounts of such semiconductor devices, which are small in size, it is difficult to ensure that each mould will fit 100% perfectly and there will be no imperfections of the production process. Especially, in cases where encapsulation should be only from one side of the metal frame - it is difficult to ensure that there will be no flashes of the encapsulating material on the other side of said metal frame. Such flashes are undesired since they can act as a thermal insulation - so they aren't allowed on the sides and surfaces of the semiconductor devices that should act as a heat sink for the semiconductor product. Cleaning encapsulated packages having such undesired flashes of encapsulating material would be too expensive and time consuming.

Accordingly, the goal of the present disclosure is to improve existing techniques of production to minimize the risk of such flashes occurring when producing semiconductor products.

### SUMMARY OF THE DISCLOSURE

According to a first example of the disclosure, there is provided a method of manufacturing a singulated semiconductor product from a package,
wherein said package comprises a bottom frame, a clip matrix, at least one semiconductor component located between said frame and said clip matrix, and an encapsulating material,
wherein the part of the bottom frame that supports the at least one semiconductor component is a die paddle, and on the sides of the at least one die paddle there are tie bars, that extend away from the die paddle towards outer part of the bottom frame and other die paddles - if such are present,
wherein at least two microleads extend away from the parts of the clip matrix that covers the at least one semiconductor component, and at least two clip tie-bars also extend away from sides of said parts of the clip matrix, similarly to how the tie bars extend away from the die paddles.

Said method comprises the following steps:
a) providing the bottom frame with the clip matrix with at least one semiconductor component and placing them in a mould cavity,
b) closing the mould,
c) moving a number of retractable pins through openings in the mould, so that tips of the pins come into contact with the tie bars or the clip-tie bars predetermined locations,
d) performing moulding operation using the encapsulating material,
e) retracting said retractable pins away from the package,
f) opening the mould,
g) removing the package from the mould,
h) singulating the package into at least one separate product by sawing along predetermined lines and trimming the microleads.

According to the present disclosure, the retractable pins are shaped such, that cross section of each of the pins is either the same along the part of the pin that comes into contact with the encapsulating material or the cross section of the pins is smallest at the tip and increases along the part of the pin that comes into contact with the encapsulating material,
wherein after the retraction of the pins in step e) there are notches formed within the encapsulating material.

Such method, including all disclosed steps and means utilized for carrying the method out - allows to significantly decrease the risk of the flashes occurring on the side of the frame of the package that is designed to remain purely metallic.

Preferably, in step c) the retractable pins come into contact with the tie bars.

Alternatively, in step c) the retractable pins come into contact with the clip tie-bars.

Preferably, the cross section of the pins is smallest at the tip and increases along the part of the pin that comes into contact with the encapsulating material.

Such design of the retractable pins helps to limit the stresses that can occur in the material of the package after the encapsulation - it makes it easier to withdraw the pins from the encapsulating material and obtain notches with smooth side walls.

Preferably, in step a) the bottom frame is located below the clip matrix and in step c) the pins are moved in a downward direction.

Alternatively, in step a) the bottom frame is located above the clip matrix and in step c) the pins are moved in an upward direction.

Preferably, in step c) the pins are moved such that they exert a holding pressure.

Exerting a holding pressure via the pins helps even further in minimizing the risk of flashes of the encapsulating material - it should be just noted that said pressure shouldn't be too high, so that it doesn't cause deformations of the bottom frame or the clip matrix.

Preferably, the retractable pins are made of metal.

Preferably, in step h) the sawing is performed across the notches left by the pins in the encapsulating material.

Preferably, the tips of the retractable pins (6) are at least 50 micrometers wide.

Preferably, the retractable pins have the shape of a truncated cone, wherein angle between the side walls of this cone is between 0 and 90 degrees.

Preferably, the moulding in step d) is carried out such, that the side of the bottom frame that is opposite to the side with the at least one semiconductor component and the clip matrix - is leveled flush with or raised above the surrounding encapsulating material.

The present disclosure also pertains to a singulated semiconductor product manufactured in accordance with the disclosed method, the singulated semiconductor product at least comprising:
a bottom frame, a clip matrix and a semiconductor component located between said frame and clip matrix, that are encased in encapsulating material,
wherein the part of the bottom frame that supports the semiconductor component is a die paddle, and on the sides of the die paddle there are at least two tie bars, that extend away from the die paddle,
wherein at least two microleads extend away from the parts of the clip matrix that covers the semiconductor component, and at least two clip tie-bars also extend away from sides of said parts of the clip matrix, similarly to the tie bars of the die paddle,
wherein the product has four side walls,
wherein the first two side walls that are opposite to each other are inclined at an angle, and these side walls contain at least two microleads,
wherein the other two side walls that are opposite to each other are perpendicular and are formed by sawing, and these side walls contain at least two tie bars or at least two tie bars and two clip tie-bars,
wherein the two perpendicular side walls formed by sawing each contain at least one notch, which extends through the encapsulating material and exposes the at least two tie bars or the at least two clip tie-bars present in these side walls.

Preferably, the notches have cross section that is smallest near the exposed tie bars or clip tie-bars and increases through the thickness of the encapsulating material.

Such notches have shape, especially cross section, directly corresponding to the shape of the retractable pin/pins.

### BRIEF DESCRIPTION OF THE DRAWINGS

The disclosure will now be discussed with reference to the drawings, which show:
Figure 1 depicts exemplary set of parts forming a package of encapsulated semiconductor products in top view and the side view, with retractable pins visible on the side view,
Figure 2 depicts exemplary way of how to singulate the package from Figure 1 into separate products, with visible sawing lines and notches left by the retractable pins,
Figure 3 depicts exemplary semiconductor product obtained by the first embodiment of the disclosed method in three views - perspective, top and from the side,
Figure 4 depicts the product from Figure 3 from the side, which is not visible on Figure 3,
Figure 5 depicts exemplary semiconductor product obtained by the second embodiment of the disclosed method in perspective view from the top side,
Figure 6 depicts the product from Figure 5 in perspective view from the bottom side,

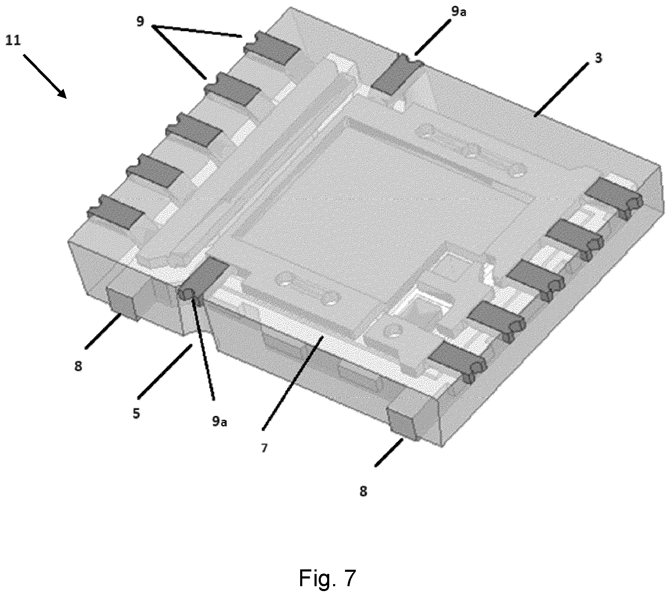

Figure 7 depicts a perspective view of the product from Figure 5, having semitransparent encapsulating material,
Figure 8 depicts an exemplary side view of the products, with a retractable pin located in a notch, and
Figure 9 depicts a product from Figure 8 with the retractable pin removed.

### DETAILED DESCRIPTION OF THE DISCLOSURE

For a proper understanding of the disclosure, in the detailed description below corresponding elements or parts of the disclosure will be denoted with identical reference numerals in the drawings.

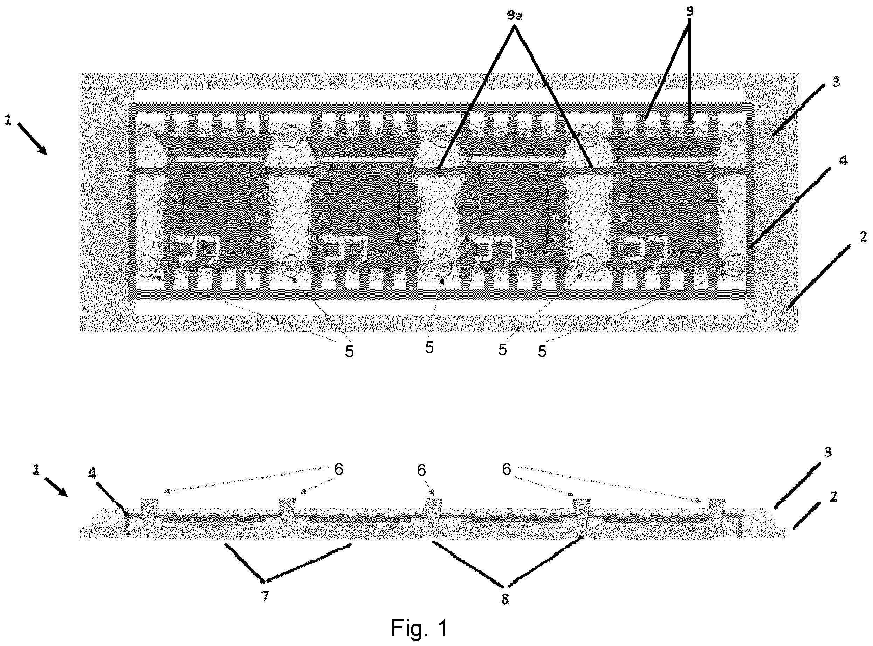

Figure 1 presents an already formed package 1, with visible parts thereof - a bottom frame 2, a clip matrix 4, an encapsulating material 3.

Larger pieces of the bottom frame 2 serve as die paddles 7, on which there are located semiconductor components that are then covered by larger pieces of the clip matrix 4.

Away from the die paddles 7 extend tie bars 8, that connect the neighboring die paddles 7 to each other and - the side ones to the outer part of the bottom frame 2.

Away from the clip matrix 4 extend microleads 9, that connect the parts of the clip matrix 4 that cover the die paddles 7 with the outer part of the clip matrix 4. These microleads 9 serve as terminals in a finished semiconductor product. Furthermore, similarly to how tie bars 8 extend away from the die paddles 7 - clip matrix 4 also comprises clip tie-bars 9a that extend away on the sides of the larger parts of the clip matrix 4 that cover their respective die paddles 7. Said clip tie-bars 9a help in stabilizing the shape of the clip matrix 4 during the manufacturing process.

Even though on Figure 1 there are visible numerous tie bars (8) (four per each die paddle 7) and numerous microleads 9 (in total ten microleads 9 per each die paddle 7) and two clip tie-bars 9a, it should be understood that the present disclosure does not require to have such exact amounts of those. The minimal number of microleads 9, clip tie-bars 9a and tie bars 8 associated with each finished and singulated product 11 is at least two of each. Four tie bars 8, two clip tie-bars 9a and ten microleads 9 in each singulated product is only a preferable variant.

Figure 1 - the side view - present also retractable pins 6 as they are moved to be in contact with the tie bars 8 of the bottom frame 2. Correspondingly - the top view of Figure 1 shows notches 5 created in the encapsulating material 3 and located on the tie bars 8 of the package 1.

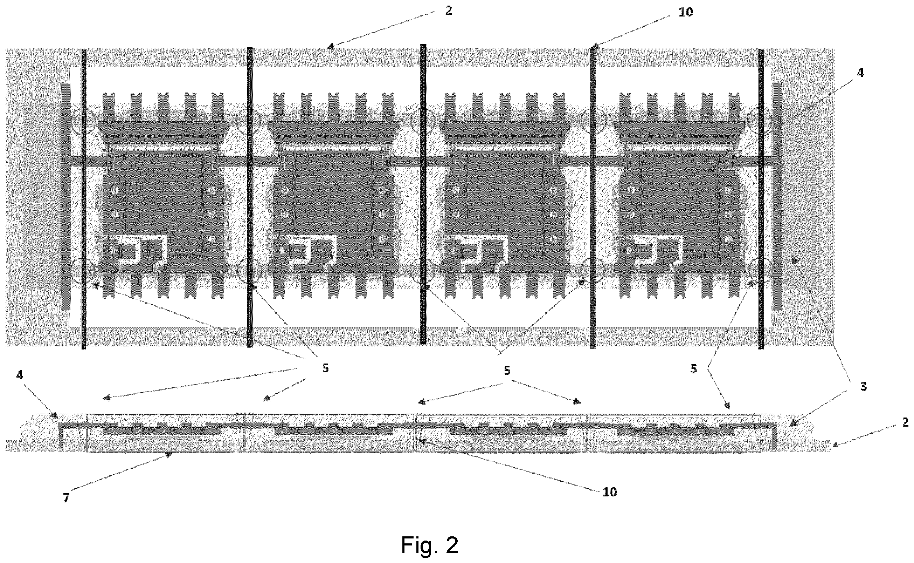

Figure 2 presents how the package 1 from Figure 1 is further singulated into separate semiconductor products 11 - by sawing along the saw lines 10, wherein the saw lines 10 go across the notches 5 (compare Figure 1 with Figure 2). After the singulation into separate products 11 - the microleads 9 also are trimmed, to complete the separation of the singulated product 11 from the outer part of the clip matrix 4.

In other embodiments - the abovementioned steps are carried out in a reversed order - such that the microleads 9 are trimmed before the sawing along the saw lines 10.

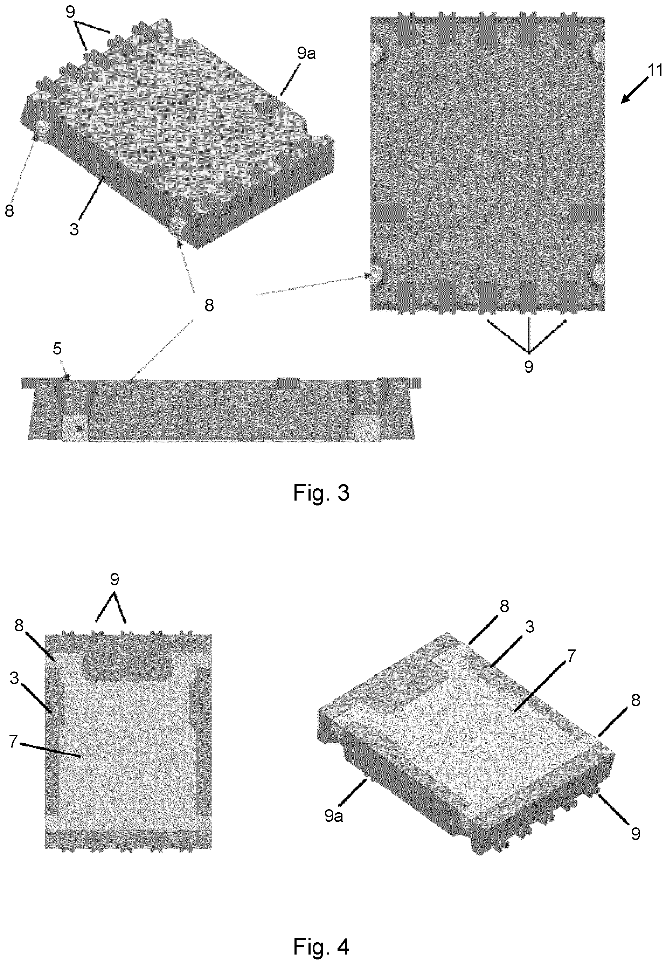

Final singulated product 11 thus created is shown on Figure 3. The geometry of the singulated product 11 is generally rectangular when viewed from the top, with two pairs of side walls. First pair of side walls is inclined (trapezoid when viewed from the side - compare with Figure 3, the side view on the bottom) - these walls are created during the moulding operation in the mould cavity, and in a preferable embodiment of the present disclosure - from these walls extend the microleads 9. Second pair of the side walls is vertical - it is created by sawing the package 1 into singulated products 11, and in a preferable embodiment of the present disclosure - these walls contain the tie bars 8, and also preferably - at least one clip tie-bar 9a each.

Notches 5 are visible on Figure 3, and these notches 5 have a preferable geometry of a truncated cone, with a smallest cross section of these notches 5 being at the tie bars 8, and the largest cross section at the surface of the encapsulating material 3.

It should be noted, that the notches 5 presented on Figures 1, 2 and 3 have the shape of a truncated cone - since it is highly preferable to allow for easier retraction of the pins 6 without risking damaging the package, but other geometries are also possible for the notches 5.

In other embodiments of the present disclosure - the notches 5 may be cylindrical (i.e. with an equal cross section within the encapsulating material 3), and the shape of the basis may be circular, triangular, rectangular, penta- or hexagonal, or any other. Such embodiments require more consideration as to how to support the formed package 1 in a mould cavity, in order to minimize the risk of damaging the package 1 when retracting the pins.

In other embodiments - the notches 5 may have a cross section that increases gradually or in steps, wherein the geometries that increase gradually are most preferable with respect to risk of damaging the packages 1 when extracting/withdrawing the pins 6 from the packages.

Figure 4 presents a singulated product from Figure 3 from the bottom side thereof - with visible die paddle 7 and tie bars 8 extending from it. The die paddle 7, from the bottom side of the singulated product 11, is completely free off encapsulating material - thanks to the retractable pins 6 keeping it stable and in place during moulding/encapsulating process.

It should be noted, that it is enough for the retractable pins 6 to be just in contact with the tie bars 8 during the moulding - in most cases such contact (without any pressure exerted by said parts) will ensure that the parts of the package 1 will be kept in place in the mould cavity. On the other hand, there might appear cases where it will be preferable for the retractable pins 6 to exert some holding pressure on the tie bars 8 during moulding - then, it should be done with consideration for the endurance of both the retractable pins 6 and the bottom frame 2, so that no parts are damaged by too much pressure.

It should be also noted, that although terms like "bottom" here are used with respect to some of the discussed parts - there is no technical limitation as to how to utilize the disclosed method. That is why - in some cases, when the bottom frame 2 and clip matrix 4 are placed within the moulding cavity - the bottom frame 2 is placed below the clip matrix 4 and the retractable pins 6 are moved towards the bottom frame 2 from the top. On the other hand - in different cases, the top frame 2 may be located in the moulding cavity above the clip matrix 4 - then the retractable pins 6 would be moved towards the tie bars 8 from the bottom.

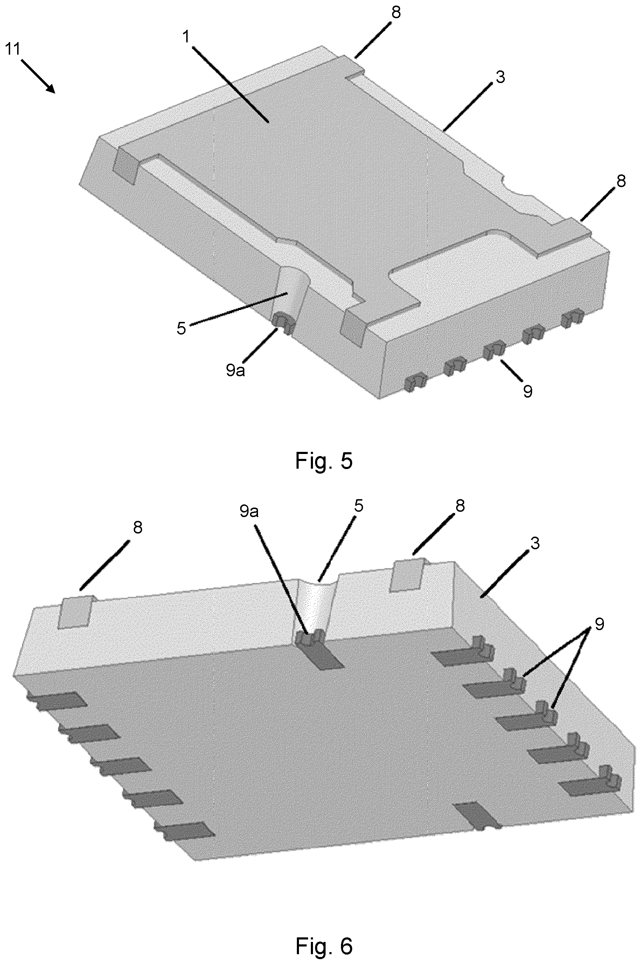

Figures 5 and 6 present a singulated product 11 according to a second main embodiment of the present disclosure - where it should be noted that most of the features of the singulated product 11 are the same as they were presented with respect to first embodiment shown on Figure 3 and 4, except for the notches 5. The notches 5 in the second main embodiment of the present disclosure are formed not at the location of the tie bars 8, but at the location of the clip tie-bars 9a (see Figure 5 and 6).

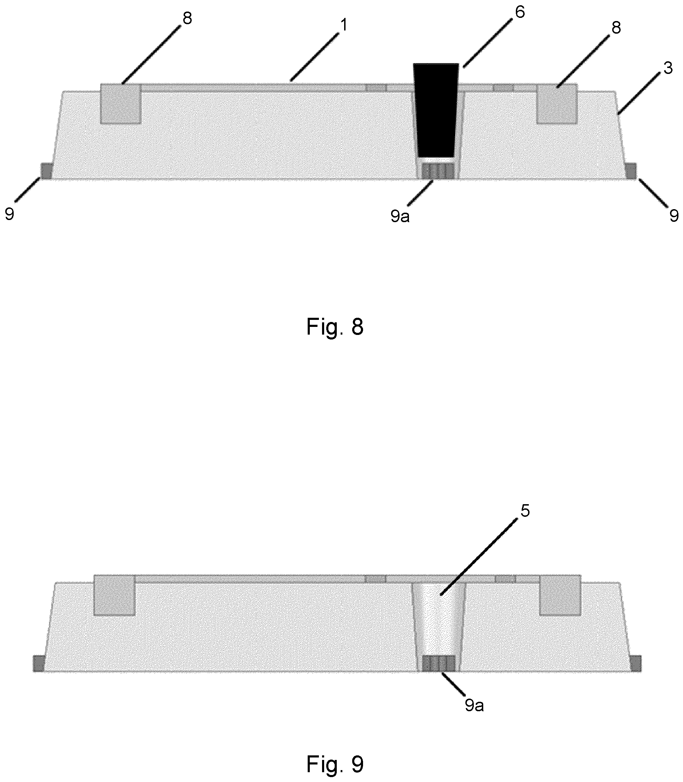

In such second embodiment - when the bottom frame 2 and the clip matrix 4 are placed inside the mould cavity, the retractable pins 6 are moved in contact with the clip tie-bars 9a (compare with Fig. 8 and 9). Other features corresponding to how it affects the disclosed method - remain essentially the same as they were with respect to the previously described embodiment(s).

Again - while Figure 3 and 4 shows a singulated product with four notches, Figures 5 and 6 show singulated product 11 with two notches - but this is presented just as an example and one would clearly understand that there are preferable embodiments of the present disclosure, where there would more than two notches 5 formed in contact with the clip tie-bars 9a.

Also - Figure 5 clearly shows, that in a final singulated product 11 (regardless of where exactly the notches 5 are located) - the surface of the die paddle 7 is exposed and is flush (at the same level as) or slightly raised with respect to the encapsulating material. Such design also helps in keeping this surface clean and thus - allowing for good dissipation of heat.

The method of producing a singulated product according to the present disclosure comprises the following steps:
a) providing the bottom frame 2 with the clip matrix 4 with at least one semiconductor component and placing them in a mould cavity,
b) closing the mould,
c) moving a number of retractable pins 6 through openings in the mould, so that tips of the retractable pins 6 come into contact with the tie bars 8 or the clip tie-bars 9a at predetermined locations,
d) performing moulding operation using the encapsulating material 3,
e) retracting said retractable pins 6 away from the package 1,
f) opening the mould,
g) removing the package 1 from the mould,
h) singulating the package 1 into at least one separate product 11 by sawing along predetermined lines and trimming the microleads 9.

As it has been mentioned previously - sawing along predetermined lines and trimming the microleads 9 can be done in any suitable order, in some embodiments the sawing is carried out before the trimming, and in others - the trimming is done before the sawing.

In some of the preferred embodiments of the present disclosure - the size of the top of the retractable pins is shown (mostly indirectly - by the size of the notches presented on the Figures) to be roughly equal to the width of the corresponding tie bar 8 or clip tie-bar 9a, but it is not limited to that.

In some preferable embodiments - the retractable pins 6 have smallest cross section at their tip (that comes into contact with tie bars 8 or clip tie-bars 9a), and to ensure this tip is not damaged when in use - it should be at least 50 micrometers wide. This however should be not understood in a limiting way, and any minimal size of the pin diameter that the tool manufacturer is capable of creating could be preferably utilized.

In some preferable embodiments - the retractable pins 6 have the shape of a truncated cone, wherein angle between the side walls of this cone is between 0 and 90 degrees, e.g. 10 degrees, 20 degrees, 30 degrees, 45 degrees, 60 degrees, 70 degrees or 80 degrees.

It should be also noted, that although Figures 1 and 2 present packages 1 with four die paddles 7 (thus - allowing to obtain four singulated products 11 therefrom), the present disclosure is not limited to this amount and it can be used to produce packages 1 comprising one or more, e.g. two, three, four, five, six, seven, eight or even more die paddles 7.

### LIST OF REFERENCE NUMERALS USED

- 1 -: package
- 2 -: bottom frame
- 3 -: encapsulating material / bar mould
- 4 -: clip matrix
- 5 -: notches formed in the encapsulating material
- 6 -: retractable mould pins
- 7 -: die paddles
- 8 -: tie bars
- 9 -: microleads
- 9a -: clip tie-bars
- 10 -: saw line
- 11 -: singulated product

## Claims

1. A method of manufacturing a singulated semiconductor product (11) from a package (1),
wherein said package (1) comprises a bottom frame (2), a clip matrix (4), at least one semiconductor component located between said frame (2) and said clip matrix (4), and an encapsulating material (3),
wherein the part of the bottom frame (2) that supports the at least one semiconductor component is a die paddle (7), and on the sides of the at least one die paddle (7) there are tie bars (8), that extend away from the die paddle (7) towards outer part of the bottom frame (2) and other die paddles (7) - if such are present,
wherein at least two microleads (9) extend away from the parts of the clip matrix (4) that covers the at least one semiconductor component, and at least two clip tie-bars (9a) also extend away from sides of said parts of the clip matrix (4), similarly to how the tie bars (8) extend away from the die paddles (7),
wherein the method comprises the following steps:
a) providing the bottom frame (2) with the clip matrix (4) with at least one semiconductor component and placing them in a mould cavity,
b) closing the mould,
c) moving a number of retractable pins (6) through openings in the mould, so that tips of the retractable pins (6) come into contact with the tie bars (8) or the clip tie-bars (9a) of the clip matrix at predetermined locations,
d) performing moulding operation using the encapsulating material (3),
e) retracting said retractable pins (6) away from the package (1),
f) opening the mould,
g) removing the package (1) from the mould,
h) singulating the package (1) into at least one separate product (11) by sawing along predetermined lines and trimming the microleads (9),
wherein the retractable pins (6) are shaped such, that cross section of each of the retractable pins (6) is either the same along the part of the pin that comes into contact with the encapsulating material (3) or the cross section of the retractable pins (6) is smallest at the tip and increases along the part of the retractable pin (6) that comes into contact with the encapsulating material (3),
wherein after the retraction of the retractable pins (6) in step e) there are notches (5) formed within the encapsulating material (3).

2. Method according to claim 1, wherein in step c) the retractable pins (6) come into contact with the tie bars (8).

3. Method according to claim 1, wherein in step c) the retractable pins (6) come into contact with the clip tie-bars (9a).

4. Method according to claim 2 or 3, wherein the cross section of the retractable pins (6) is smallest at the tip and increases along the part of the retractable pin (6) that comes into contact with the encapsulating material (3).

5. Method according to claim 2 and 4, wherein in step a) the bottom frame (2) is located below the clip matrix (4) and in step c) the retractable pins (6) are moved in a downward direction.

6. Method according to claim 2 and 4, wherein in step a) the bottom frame (2) is located above the clip matrix (4) and in step c) the retractable pins (6) are moved in an upward direction.

7. Method according to claim 2, 3, 4, 5 or 6, wherein in step c) the retractable pins (6) are moved such that they exert a holding pressure.

8. Method according to claim 2, 3, 4, 5, 6 or 7, wherein the retractable pins (6) are made of metal.

9. Method according to claim 2, 3, 4, 5, 6, 7 or 8, wherein in step h) the sawing is performed across the notches (5) left by the retractable pins (6) in the encapsulating material (3).

10. Method according to claim 2, 3, 4, 5, 6, 7, 8 or 9, wherein the tips of the retractable pins (6) are at least 50 micrometers wide.

11. Method according to claim 2, 3, 4, 5, 6, 7, 8, 9 or 10, wherein the retractable pins (6) have the shape of a truncated cone, wherein angle between the side walls of this cone is between 0 and 90 degrees.

12. Method according to any of the proceeding claims from 2 to 11, wherein the moulding in step d) is carried out such, that the side of the bottom frame (2) that is opposite to the side with the at least one semiconductor component and the clip matrix (4) - is leveled flush with or raised above the surrounding encapsulating material (3).

13. A singulated semiconductor product (11) manufactured in accordance with one or more of the method claims 1-12, the singulated semiconductor product (11) at least comprising:
a bottom frame (2), a clip matrix (4) and a semiconductor component located between said frame (2) and clip matrix (4), that are encased in encapsulating material (3),
wherein the part of the bottom frame (2) that supports the semiconductor component is a die paddle (7), and on the sides of the die paddle (7) there are at least two tie bars (8), that extend away from the die paddle (7),
wherein at least two microleads (9) extend away from the parts of the clip matrix (4) that covers the semiconductor component, and at least two clip tie-bars (9a) also extend away from sides of said parts of the clip matrix (4), similarly to the tie bars (8) of the die paddle (7),
wherein the product has four side walls,
wherein the first two side walls that are opposite to each other are inclined at an angle, and these side walls contain at least two microleads (9),
wherein the other two side walls that are opposite to each other are perpendicular and are formed by sawing, and these side walls contain at least two tie bars (8) or at least two tie bars (8) and two clip tie-bars (9a),
wherein the two perpendicular side walls formed by sawing each contain at least one notch (5), which extends through the encapsulating material (3) and exposes the at least two tie bars (8) or the at least two clip tie-bars (9a) present in these side walls.

14. The singulated semiconductor product (11) according to claim 13, wherein the notches (5) have cross section that is smallest near the exposed tie bars (8) or clip tie-bars (9a) and increases through the thickness of the encapsulating material (3).
